# FASCICULE DE BREVET EUROPEEN

(11) **EP 0 475 835 B1**
(45) Date de publication et mention de la délivrance du brevet: **16.02.1994**
(21) Numéro de dépôt: 91402406.2
(22) Date de dépôt: 10.09.1991
(51) Int. Cl.: H03F 3/217

(54) **Circuit d'amplification à découpage pour la fourniture d'un courant proportionnel à une tension, et système de déflexion électromagnétique utilisant au moins un tel circuit**
Zerhackerverstärkerschaltung zur Versorgung eines Stroms, der proportional zu einer Spannung ist und eine elektromagnetische Ablenkeinheit, die eine solche verwendet
Chopper amplifier circuit for supplying a current proportional to a voltage and electromagnetic deflection system utilizing such a circuit

(30) Priorité: 14.09.1990 FR 9011372
(43) Date de publication de la demande: 18.03.1992
(73) Titulaire: SEXTANT AVIONIQUE, F-92368 Meudon la Forêt Cédex (FR)
(72) Inventeur: Lucas, Jean-Christophe, F-92045 Paris la Défense (FR); Sontag, Yves, F-92045 Paris la Défense (FR)
(74) Mandataire: Courtellemont, Alain

(56) Documents cités:
- EP-A- 0 082 282
- EP-A- 0 430 577
- US-A- 3 508 109
- US-A- 4 346 349
- US-A- 4 446 440
- IEEE TRANSACTIONS ON POWER ELECTRONICS, vol. PE-1, no. 1, janvier 1986, pages 48-54, NY, US; G.B. YUNDT: "Series- or parallel-connected composite amplifiers"

## Description

La présente invention se rapporte aux circuits d'amplification à découpage pour la fourniture d'un courant proportionnel à une tension et en particulier à de tels circuits conçus pour fournir, à des bobines de déflexion de tubes cathodiques, les courants nécessaires à leur fonctionnement.

Dans ce qui suit il sera surtout question de circuits d'amplification alimentant des bobines de déflexion pour effectuer un balayage cavalier de l'écran d'un tube cathodique, c'est-à-dire un balayage où le faisceau peut parcourir l'écran de façon quelconque ; l'alimentation en courant des bobines de déflexion pose alors des problèmes cruciaux de dissipation d'énergie. Mais le circuit selon l'invention trouve son application partout où doit être fournie une puissance importante à une charge quelconque.

Une bobine de déviation pouvant être assimilée à une inductance, la tension à ses bornes est de la forme L.dI/dt où L représente l'inductance de la bobine et dI/dt la dérivée par rapport au temps, t, du courant, I, qui traverse la bobine. Le déplacement du faisceau sur l'écran étant sensiblement proportionnel à I, le terme dI/dt peut être identifié à la vitesse du tracé sur l'écran.

Dans un balayage cavalier lorsque l'image à tracer sur l'écran est chargée, c'est-à-dire remplie de détails, la vitesse de tracé doit être importante et donc les tensions d'alimentation relativement élevées.

De plus, l'énergie de déviation nécessaire est de l'ordre du millijoule, ce qui implique des courants de déflexion de quelques ampères.

Il apparaît donc que la puissance nécessaire au fonctionnement d'un système de déflexion électromagnétique de type cavalier est élevée. D'autre part, le déviateur étant réactif, la quasi totalité de la puissance consommée est dissipée dans l'étage final de l'amplificateur.

En conséquence, il est fréquent d'avoir à dissiper quelques dizaines de watts dans les transistors de sortie, ce qui n'est pas sans poser d'importants problèmes dans les visualisations compactes. L'utilisation d'amplificateurs à découpage réduit les problèmes de dissipation, mais ne permet pas d'obtenir un signal de qualité suffisante (voir US-A-3508109)

Pour y parvenir il est connu d'associer, de façon complémentaire, dans un même circuit d'amplification à découpage, un amplificateur linéaire et un amplificateur à découpage, par exemple comme divulgué dans IEEE TRANSACTIONS ON POWER ELECTRONICS, vol. PE-1, no. 1, janvier 1986, pages 48-54, NY, US; G.B. YUNDT: "Series- or parallel-connected composite amplifiers". Le circuit d'amplification à découpage pour la fourniture, à une charge, d'un courant de sortie proportionnel à une tension d'entrée, comporte alors un amplificateur linéaire et un amplificateur à découpage, dont la sortie est couplée à la charge ; l'amplificateur linéaire est un amplificateur de puissance commandé pour fournir un courant fonction de la différence entre la tension d'entrée et une tension proportionnelle au courant de sortie, sa sortie est couplée à la charge, de manière que le courant qu'il fournit constitue une partie du courant de sortie ; l'autre partie du courant de sortie est fournie par l'amplificateur à découpage qui est commandé en fonction du courant fourni par l'amplificateur linéaire.

Dans les circuits d'amplification à découpage connu la commande de l'amplificateur à découpage n'est pas assurée de façon satisfaisante et il en résulte des difficultés de réalisation aux fréquences élevées et un rendement faible.

La présente invention a pour but d'éviter ou pour le moins de réduire ces inconvénients. Ceci est obtenu en ne fournissant, par l'amplificateur à découpage, qu'un courant qui tende à faire diminuer, en valeur absolue, le courant fourni par l'amplificateur linéaire, et cela uniquement lorsque le courant de sortie du circuit d'amplification est supérieur à une valeur donnée ; ainsi, en particulier, tout risque de fournir simultanément, à partir de l'amplificateur à découpage, deux courants de sens opposés est évité et la commutation de ces courants est facilitée.

Selon l'invention il est proposé un circuit d'amplification à découpage pour la fourniture, à une charge, d'un courant de sortie proportionnel à une tension d'entrée, comportant un amplificateur linéaire et un amplificateur à découpage, dont la sortie est couplée à la charge, l'amplificateur linéaire étant un amplificateur de puissance commandé pour fournir un courant fonction de la différence entre la tension d'entrée et une tension proportionnelle au courant de sortie et ayant une sortie couplée à la charge, de manière que le courant qu'il fournit constitue une partie du courant de sortie, l'autre partie du courant de sortie étant fournie par l'amplificateur à découpage, cet amplificateur à découpage étant commandé en fonction du courant fourni par l'amplificateur linéaire, caractérisé en ce que la commande de l'amplificateur à découpage est réalisée par un circuit qui comporte des moyens de mesure et de commande pour commander, seulement lorsque le courant de sortie est supérieur en valeur absolue à une valeur donnée, la fourniture par l'amplificateur à découpage d'un courant qui tend à augmenter, en valeur absolue, le courant de sortie de manière à tendre à réduire, en valeur absolue, le courant fourni par l'amplificateur linéaire.

La présente invention sera mieux comprise et d'autres caractéristiques apparaîtront à l'aide de la description ci-après et des figures s'y rapportant qui représentent :
- la figure 1, le schéma d'un circuit qui constitue une étape sur le chemin qui a conduit à l'invention,
- les figures 2 à 4 des schémas de circuits selon l'invention.

Dans les différents schémas les éléments correspondants sont désignés par les mêmes repères.

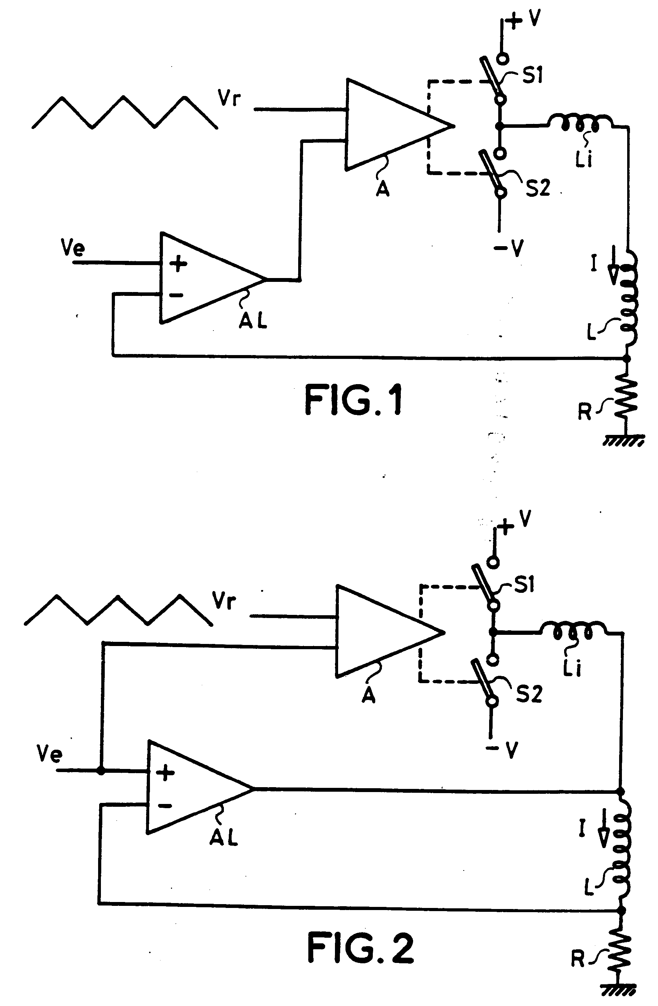

La figure 1 représente le schéma d'un circuit d'amplification qui a été imaginé par l'inventeur dans le but de fournir, en fonction d'une tension d'entrée Ve un courant I dans une bobine de déflexion L, pour tube cathodique utilisé en balayage cavalier.

Le circuit selon la figure 1 comporte un amplificateur à découpage schématisé par un amplificateur A, à deux entrées et deux sorties, et par deux interrupteurs S1, S2 montés en série entre deux points sur lesquels sont respectivement appliquées deux tensions +V et -V ; l'ouverture et la fermeture des interrupteurs S1, S2, qui sont, en fait, des transistors, sont commandées par les signaux de sorties de l'amplificateur A. Les deux entrées de l'amplificateur A reçoivent respectivement un signal de découpage, Vr, et le signal de sortie d'un amplificateur différentiel linéaire AL ; l'amplificateur AL reçoit sur son entrée "+" la tension d'entrée Ve. Le signal de découpage est une tension en dent de scie, de valeur constante, qui commande le découpage.

La sortie de l'amplificateur à découpage, c'est-à-dire le point commun aux interrupteurs S1 et S2, est reliée, par une bobine de lissage Li, à la première extrémité de la bobine de déflexion L, dont la seconde extrémité est reliée à la masse par une résistance R et est réunie à l'entrée "-" de l'amplificateur différentiel AL.

L'amplificateur AL fait la différence entre la tension d'entrée Ve et la tension aux bornes de la résistance R ; l'amplificateur à découpage tend à ramener cette différence à zéro en faisant varier la valeur du courant I fourni à la bobine de déflexion L.

L'inconvénient majeur du circuit selon la figure 1, est la nécessité de découper avec un signal Vr dont la fréquence doit être le double de celle des signaux d'entrée ; comme le spectre de fréquence des signaux d'entrée est en général supérieur à 1 MHz pour un balayage cavalier, il est nécessaire, dans la pratique, de découper à au moins 4MHz. A de telles fréquences les pertes par commutation deviennent comparables aux pertes par conduction dans un amplificateur linéaire. De plus des bruits de commutation, difficiles à supprimer, polluent l'image.

Le circuit selon la figure 1 est donc apparu comme étant inexploitable, du moins avec les transistors interrupteurs actuellement disponibles sur le marché.

Le caractère inductif d'une bobine de déviation interdisant des variations rapides du courant qui la traversent, les vitesses de tracé sur l'écran sont nécessairement limitées et, en conséquence, la majeure partie du spectre du courant est à basse fréquence. Ceci est mis à profit, dans les circuits qui vont maintenant être décrits, pour traiter les composantes à basse fréquence et fort courant à l'aide d'un amplificateur à découpage dont la fréquence de fonctionnement n'est pas supérieure à la fréquence supérieure du spectre à transmettre, afin que les pertes par commutation soient acceptables. Par contre les composantes à haute fréquence du courant dans la bobine de déviation, qui sont limitées en amplitude, sont traitées à l'aide d'un amplificateur linéaire rapide mais de relativement faible puissance.

Le schéma du circuit selon la figure 2 se distingue du schéma du circuit selon la figure 1 par le fait que la sortie de l'amplificateur différentiel linéaire AL est reliée, non plus à une des entrées de l'amplificateur A mais au point commun des bobines de lissage Li et de déviation L, et par le fait que l'entrée de l'amplificateur A qui recevait le signal de sortie de l'amplificateur AL reçoit ici la tension d'entrée Ve.

L'amplificateur linéaire AL possède un gain élevé de manière à asservir la tension aux bornes de la résistance R et donc le courant I dans la bobine L, à la tension d'entrée Ve. Dans ce circuit, l'amplificateur à découpage, schématisé sur la figure 2 par l'amplificateur A et les interrupteurs S1 et S2, fournit la majeure partie du courant I de la bobine de déviation ; l'amplificateur linéaire AL n'a plus qu'à fournir le complément, et participe à la suppression du bruit engendré par l'amplificateur A.

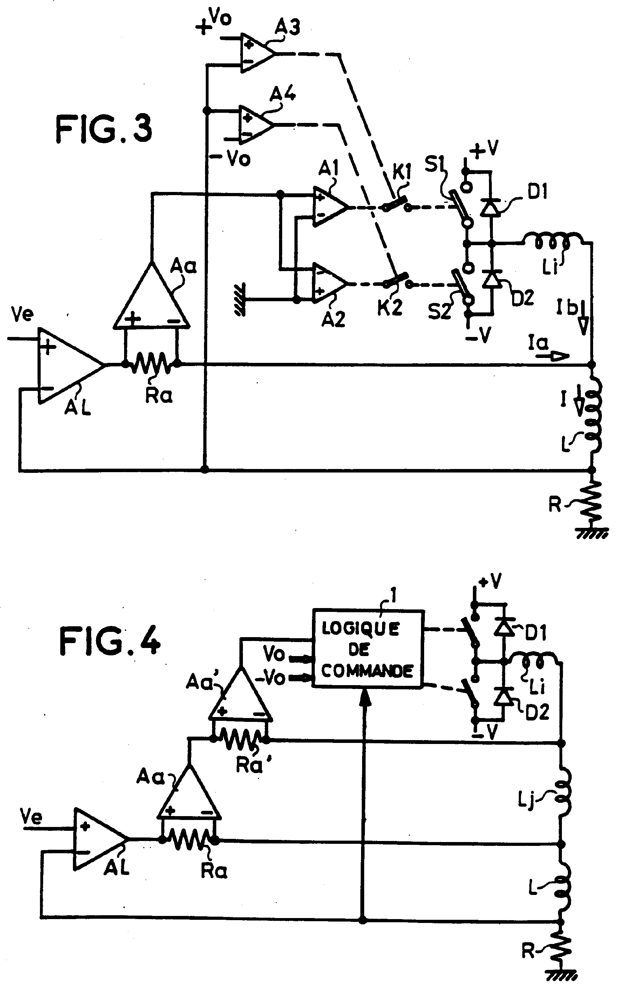

Le circuit selon la figure 2 nécessite qu'il y ait équivalence de gain entre les amplificateurs AL et A, ce qui n'est pas simple à obtenir ; c'est pourquoi le circuit selon la figure 2 a été modifié pour aboutir au circuit selon la figure 3, dans lequel le découpage est piloté directement par le courant de sortie de l'amplificateur linéaire et dans lequel l'amplificateur à découpage est du type à relaxation naturelle, c'est-à-dire ne nécessite plus le signal Vr, en dents de scie, comme dans les circuits selon les figures 1 et 2.

Le circuit selon la figure 3 comporte un amplificateur différentiel linéaire AL dont l'entrée "+" reçoit une tension d'entrée Ve qui constitue le signal de commande à partir duquel doit être fourni, à une bobine de déflexion L de 120 microhenry, un courant I linéairement proportionnel à Ve.

La sortie de l'amplificateur AL est reliée par une résistance Ra de 1 ohm à la première extrémité de la bobine L dont la seconde extrémité est reliée directement à l'entrée "-" de l'amplificateur AL, ainsi qu'à la seconde entrée d'un comparateur classique A3 et à la première entrée d'un comparateur classique A4, et, à travers une résistance R de 0,5 ohm, à la masse. La première entrée du comparateur A3 reçoit une tension continue positive, fixe, de référence, +Vo, et la seconde entrée du comparateur A3 une tension -Vo.

Les deux extrémités de la résistance Ra sont respectivement reliées aux entrées d'un amplificateur opérationnel linéaire Aa dont la sortie est reliée aux premières entrées de deux comparateurs rapides A1, A2 dont les secondes entrées sont reliées à la masse.

Les deux comparateurs A1, A2 forment avec deux interrupteurs K1, K2 montés en série avec leurs sorties respectives et avec deux interrupteurs S1, S2 respectivement commandés par les signaux de sortie des comparateurs A1, A2 à travers les interrupteurs K1, K2, un amplificateur à découpage, qui fonctionne en relaxation naturelle comme il sera montré dans ce qui suit.

Les signaux de sortie des comparateurs A3, A4 commandent respectivement les interrupteurs K1 et K2. Il est à préciser que, comme dans les circuits selon les figures 1 et 2, les quatre interrupteurs de la figure 3, qui ont été représentés comme de simples contacts mécaniques, sont en réalité, dans l'exemple décrit, des transistors.

Les interrupteurs S1 et S2 sont montés en série entre deux points respectivement portés à des tensions continues fixes +V = 40 volts et -V = -40 volts.

Deux diodes de récupération D1 et D2, disposées en série, sont montées en inverse entre les points de tensions +V et -V et leur point commun est relié au point commun aux interrupteurs S1 et S2 et à la première extrémité d'une inductance de lissage Li de 40 microhenry ; la seconde extrémité de l'inductance Li est reliée à la première extrémité de la bobine de déflexion, L.

Ainsi réalisé le circuit selon la figure 3 fournit à la bobine L un courant I qui est la somme du courant Ia fourni par l'amplificateur AL, étant entendu que l'amplificateur Aa ne prend pratiquement pas de courant à la sortie de l'amplificateur AL, et du courant Ib fourni par l'amplificateur à découpage.

Comme tout le courant I qui traverse la bobine L traverse la résistance R, l'entrée à très forte impédance de l'amplificateur AL ne consommant pratiquement aucun courant, l'entrée "-" du comparateur A3 et l'entrée "+" du comparateur A4, qui sont aussi des entrées à très forte impédance, sont portées au potentiel R.I ; ainsi en écrivant que Vo est le produit de la résistance R par un courant continu, positif, fixe Io, les comparateurs A3 et A4 comparent respectivement Vo à R.I et R.I à -Vo, c'est-à-dire qu'ils comparent respectivement Io à I et I à -Io. Le comparateur A3 ne ferme l'interrupteur K1 et donc n'autorise l'action du comparateur A1 sur l'interrupteur S1, que lorsque I est supérieur à Io ; le comparateur A4 ne ferme l'interrupteur K2 et donc n'autorise l'action du comparateur A2 sur l'interrupteur S2, que lorsque I est inférieur à -Io. Ainsi l'amplificateur à découpage A1, A2, K1, K2, S1, S2 ne fournit un courant, positif ou négatif, que lorsque I est supérieur à Io ou inférieur à -Io, c'est-à-dire lorsque |I| > Io ; la valeur de Io est choisie faible ; pour |I| < Io, seul l'amplificateur AL fournit du courant à la bobine L, et, du fait que ce courant est faible, le rendement de l'amplificateur AL n'est pas détérioré.

Le fait que l'amplificateur à découpage ne fournit pas de courant pour |I| < Io simplifie grandement les circuits de commande de s interrupteurs S1, S2. En effet, sinon, pour I voisin de 0, il faudrait commander quasi simultanément les deux interrupteurs S1, S2. Il s'en suivrait des conductions simultanées des deux interrupteurs S1, S2 et donc une mise en court-circuit pendant des temps très courts des alimentations qui fournissent les tensions +V et -V, d'où une dégradation du rendement de l'amplificateur et une fatigue exagérée des transistors S1 et S2.

Dans le circuit selon la figure 3 l'amplificateur linéaire AL débite la totalité des courants à basse fréquence tant qu'ils restent de faible amplitude ; ensuite l'amplificateur à découpage ferme celui des interrupteurs S1 et S2 qui entraîne une augmentation en valeur absolue du courant I afin de conserver l'égalité I = Ia + Ib, d'où une diminution de Ia qui conduit à une ouverture de l'interrupteur et, Ib étant alors nul, Ia augmente à nouveau et fait se refermer l'interrupteur. En supposant, pour simplifier la compréhension, que Ve est constant et donc que I est constant, il se produit aussi une oscillation naturelle de l'amplificateur à découpage, l'amplificateur linéaire AL compensant les imperfections de l'amplificateur à découpage qui fonctionne en tout ou rien.

Le fonctionnement du circuit selon la figure 3 peut être décrit comme suit :
- pour - Io < I < Io, c'est-à-dire pour les faibles valeurs de I l'amplificateur est suffisant pour fournir seul le courant I à la charge constituée par la bobine de déflexion L ; les comparateurs A3 et A4 ne ferment pas les interrupteurs K1, K2 et empêchent donc les comparateurs A1, A2 de commander la fermeture des interrupteurs S1, S2 ; le courant Ib est donc nul et I est égal à Ia.
- pour I > Io, le comparateur A3 ferme l'interrupteur K1 tandis que l'interrupteur K2 reste ouvert, si bien que seul l'interrupteur S1 peut se fermer et fournir ainsi le courant Ib à la bobine L à partir de la tension d'alimentation +V ; en effet l'interrupteur K2 n'étant pas fermé, le comparateur A4 ne risque pas de fermer l'interrupteur S2 et d'autoriser ainsi la fourniture de courant à la bobine L à partir de la tension -V. L'interrupteur S1 se ferme de manière à fournir un courant Ib à la bobine de déflexion L pour compléter le courant Ia fourni par l'amplificateur linéaire AL ; cette fermeture se fait donc au rythme des besoins en courant de complément au courant Ia et ces besoins sont mesurés grâce à l'amplificateur Aa suivi du comparateur A1,
- pour I < - Io, le comparateur A3 empêche l'interrupteur T1 de se refermer et cette fois c'est l'interrupteur S2 qui fournit, grâce à la tension d'alimentation -V, le courant Ib au rythme des besoins en courant de complément au courant Ia.

Il est à noter que, les variations du courant I dans la bobine de déflexion L étant relativement lentes, le temps que met le courant I pour passer de la valeur Io à la valeur -Io, ou l'inverse, est non négligeable ; les comparateurs A3, A4 peuvent donc être des comparateurs ordinaires . Il n'en n'est pas de même pour les comparateurs A1, A2 car ces comparateurs rapides déterminent en partie la durée d'ouverture et de fermeture des interrupteurs S1, S2 et doivent donc réagir très rapidement aux variations du courant Ia ; les comparateurs A1, A2 doivent donc être des comparateurs rapides . Il est à noter également qu'à l'ouverture d'un des interrupteurs S1 ou S2 , le courant Ib tendant à rester constant du fait de la présence de la bobine Li, l'une des diodes D2 ou D1 se met à conduire, ce qui a pour effet de recharger les alimentations et donc améliore le rendement.

La figure 4 représente un circuit selon l'invention, destiné à une visualisation à très haute définition sur écran cathodique. Sur cette figure apparaît un bloc, 1, appelé logique de commande qui correspond à la partie du circuit de la figure 3 comprenant les comparateurs A1 à A4 et les interrupteurs K1, K2. Le circuit de la figure 4 se distingue de celui de la figure 3 par l'adjonction d'une bobine de lissage Lj, d'un amplificateur opérationnel linéaire Aa' et d'une résistance Ra' ; la bobine Lj est disposée en série entre les bobines Li et L ; la résistance Ra' est montée en série entre la sortie de l'amplificateur Aa et le point commun aux deux bobines de lissage Li et Lj ; l'amplificateur Aa' couple l'amplificateur Aa à la logique de commande et a, pour cela, ses deux entrées reliées aux extrémités de la résistance Ra' - ceci a pour effet de doubler le lissage passif par la bobine Lj et actif par l'amplificateur Aa.

La présente invention n'est pas limitée aux exemples décrits qui se rapportent à la déflexion électromagnétique d'un faisceau d'électrons. Elle est, par exemple, applicable à la réalisation d'un circuit d'amplification à rendement amélioré pour audiofréquences.

## Revendications

1. Circuit d'amplification à découpage pour la fourniture, à une charge (L), d'un courant de sortie (I) proportionnel à une tension d'entrée (Ve), comportant un amplificateur linéaire (AL) et un amplificateur à découpage (A1, A2, K1, K2, S1, S2 ), dont la sortie est couplée à la charge, l'amplificateur linéaire étant un amplificateur de puissance commandé pour fournir un courant (Ia) fonction de la différence entre la tension d'entrée et une tension (R.I) proportionnelle au courant de sortie et ayant une sortie couplée à la charge, de manière que le courant qu'il fournit constitue une partie du courant de sortie, l'autre partie du courant de sortie étant fournie par l'amplificateur à découpage, cet amplificateur à découpage étant commandé en fonction du courant (Ia) fourni par l'amplificateur linéaire (AL), caractérisé en ce que la commande de l'amplificateur à découpage est réalisée par un circuit qui comporte des moyens de mesure et de commande (Ra-Aa, A3, A4) pour commander, seulement lorsque le courant de sortie est supérieur en valeur absolue à une valeur donnée, la fourniture par l'amplificateur à découpage (A1, A2, K1, K2, S1, S2) d'un courant (Ib) qui tend à augmenter, en valeur absolue, le courant de sortie (I) de manière à tendre à réduire, en valeur absolue, le courant (Ia) fourni par l'amplificateur linéaire.

2. Système de déflexion électromagnétique, caractérisé en ce qu'il utilise au moins un circuit d'amplification selon la revendication 1.

## Patentansprüche

1. Zerhackerverstärkerschaltung zum Liefern eines zu einer Eingangsspannung (Ve) proportionalen Ausgangsstroms (I) an eine Last (L), mit einem Linearverstärker (AL) und einem Zerhackerverstärker (A1, A2, K1, K2, S1, S2), dessen Ausgang mit der Last verbunden ist, wobei der Linearverstärker ein Leistungsverstärker ist, der so gesteuert wird, daß er einen von der Differenz zwischen der Eingangsspannung und einer zum Ausgangsstrom proportionalen Spannung (R·I) abhängenden Strom (Ia) liefert, und der einen mit der Last gekoppelten Ausgang besitzt, derart, daß der von ihm gelieferte Strom einen Teil des Ausgangsstroms bildet, wobei der andere Teil des Ausgangsstroms vom Zerhackerverstärker geliefert wird, wobei dieser Zerhackerverstärker in Abhängigkeit von dem vom Linearverstärker (AL) gelieferten Strom (Ia) gesteuert wird, dadurch gekennzeichnet, daß die Steuerung des Zerhackerverstärkers durch eine Schaltung ausgeführt wird, die Meß- und Steuermittel (Ra-Aa, A3, A4) aufweist, um die Ausgabe eines Stroms (Ib) vom Zerhackerverstärker (Al, A2, K1, K2, S1, S2) ausschließlich dann zu steuern, wenn der Absolutwert des Ausgangsstroms größer als ein gegebener Wert ist, wobei dieser Strom (Ib) bestrebt ist, den Absolutwert des Ausgangsstroms (I) zu erhöhen, derart, daß er den Absolutwert des vom Linearverstärker ausgegebenen Stroms (Ia) zu verringern sucht.

2. Elektromagnetisches Ablenksystem, dadurch gekennzeichnet, daß es wenigstens eine Verstärkerschaltung gemäß Anspruch 1 verwendet.

## Claims

1. Chopper amplification circuit for the supply, to a load (L), of an output current (I) which is proportional to an input voltage (Ve), including a linear amplifier (AL) and a chopper amplifier (A1, A2, K1, K2, S1, S2), whose output is coupled to the load, the linear amplifier being a power amplifier which is controlled in order to supply a current (Ia) as a function of the difference between the input voltage and a voltage (R.I) which is proportional to the output current and having an output coupled to the load, in such a way that the current which it supplies constitutes a part of the output current, the other part of the output current being supplied by the chopper amplifier, this chopper amplifier being controlled as a function of the current (Ia) supplied by the linear amplifier (AL), characterized in that the control of the chopper amplifier is carried out by a circuit which includes measurement and control means (Ra-Aa, A3, A4) for controlling, only when the output current is higher in absolute value than a given value, the supply by the chopper amplifier (A1, A2, K1, K2, S1, S2) of a current (Ib) which tends to increase, in absolute value, the output current (I) in such a way as to tend to reduce, in absolute value, the current (Ia) supplied by the linear amplifier.

2. Electromagnetic deflection system, characterized in that it uses at least one amplification circuit according to Claim 1.
